Europäisches Patentamt

European Patent Office

Office européen des brevets

(19)

(11) Publication number: **0 431 813 A1**

# EUROPEAN PATENT APPLICATION

(21) Application number: 90312834.6

(51) Int. Cl.⁵: **C04B 35/00**, C01G 3/00

(22) Date of filing: 26.11.90

(30) Priority: 28.11.89 US 441955
29.10.90 US 605564

(43) Date of publication of application:
12.06.91 Bulletin 91/24

(84) Designated Contracting States:
DE FR GB IT

(71) Applicant: GENERAL ATOMICS
10955 John Jay Hopkins Road
San Diego California 92121(US)

(72) Inventor: Chen, Kuo-Chun
2705 Sombrosa Street
Carlsbad, California 92009(US)
Inventor: Mazdiyasni, Khodabakhsh S.
2524 Camino Narcisco
Alpine, California 92001(US)

(74) Representative: Coxon, Philip et al
Eric Potter & Clarkson St. Mary's Court St.
Mary's Gate
Nottingham NG1 1LE(GB)

(54) Method for preparing rare earth -barium-cuprate pre-ceramic resins and super conductive materials prepared therefrom.

(57) A method of making high $T_c$ 1-2-3 superconductors having perovskite structure using solution techniques is dislcosed. The process uses two solvent systems to form a resinous pre-ceramic material having a controlled viscosity for facilitating its formation into superconducting articles such as fibers, wires, ribbons, films and the like. The process yields a pre-ceramic which is flexible and which has sufficient structural integrity to withstand normal handling.

BENZENE

I: VISCOUS
II: FLUID
(SLIGHTLY PRECIPITATED)
III: FLUID
IV: PRECIPITATED
V: COHESIVE
VI: POWDER

RESIN

i-PrOH

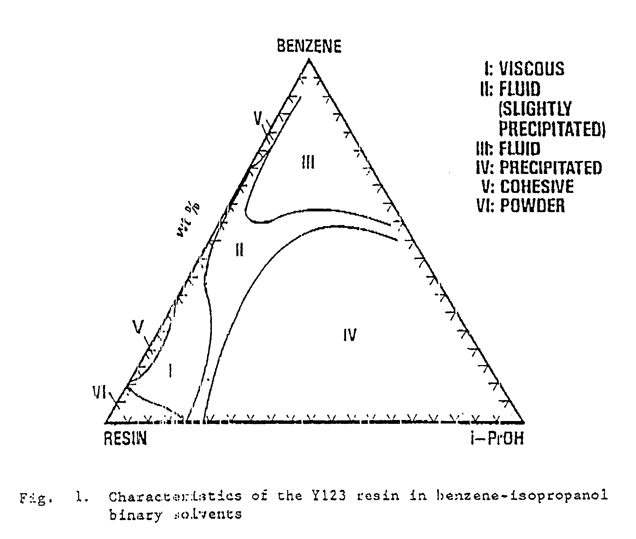

Fig. 1. Characteristics of the Y123 resin in benzene-isopropanol binary solvents

EP 0 431 813 A1

## A METHOD OF MAKING A SHAPED SUPERCONDUCTING CERAMIC ARTICLE

The present invention relates generaly to a process for preparing resinous pre-ceramic materials, also known as superconductive precursors. More particularly, the present invention relates to methods of making shaped superconducting ceramic articles. The resinous pre-ceramic materials can be converted into electrically superconducting ceramic articles having perovskite structure and the formula $ABa_2Cu_3O_{7-x}$, where A is a rare earth metal and x is from 0.5 to 0. Wires, fibers, films, ribbons, as well as bulk articles can be formed from the pre-ceramic material and converted into superconductive articles. More particularly, this invention relates to the preparation of resinous preceramic materials which are formed from homogeneous solutions and which are soluble in non-polar and alcohol solvent solutions. The use of two solvent systems allows for controllable viscosity of the pre-ceramic material and the ability to more easily form articles such as wires, ribbons, fibers, or bulk material which can then be heat treated in a dry oxygen atmosphere to yield superconductive properties.

The recent discovery of superconductive ceramics which exhibit superconductivity above 77K (liquid nitrogen boiling temperature) has generated a tremendous search for commercial applications. Particularly promising are the perovskite structured superconductors having the formula $ABa_2Cu_3O_7-x$ where A is a rare earth metal and x is from 0.5 to 0. These copper-based superconductors have been found to have a relatively high superconducting transition temperature ($T_c$). This is the temperature at which a material leaves its normal conductivity state and exhibits little or no resistance to electric current. The copper-based superconductors have been known to carry a critical current in excess of $10^5$ amp/cm$^2$ at liquid nitrogen temperature (77K).

Numerous difficulties have been encountered, however, in achieving a practical usefulness. In order to be truly useful, the superconducting material must be capable of being fabricated into specific shapes, such as wires, fibers, films, coatings and bulk articles. If these materials can be successfully manipulated to achieve a desired article or shape, applications such as microelectronic circuitry, transmission wires, power generators, magnetically levitated trains, magnetic containment fields for storing electricity as well as various medical applications become possible.

Various other factors such as proper ceramic density, sufficient capability to handle large currents, good mechanical strength and flexibility also play an important part in making a commercially viable superconducting material.

Thus far, several methods have been used to produce copper-based superconducting ceramics. Solid-state sintering was the first method of producing superconducting materials. This method required the powder oxides and carbonates of the various constituents to be mixed and reacted at high temperatures, followed by a succession of regrinding and refiring steps. Although the solid-state reaction method is found to be very convenient to form a superconductor material, X-ray diffraction analysis shows that these superconductors are usually multiphased, i.e., contain other unreacted compounds such as $BaCuO_2$ and $CuO$. More recently, superconducting ceramics have been prepared by coprecipitation methods using nitrate and/or other inorganic salt forms of the individual constituents and precipitated out of solution to the corresponding hydroxide/oxide containing carbonate forms. The precipitated mass is heated to remove water and anions impurities and then heated to ground repeatedly in the same manner as the solid-state reaction method. The advantage of this method over the solid-state method is that if the stoichiometry of the desired single phase of the superconductor is known, as it is for $YBa_2Cu_3O_{7-x}$ (the composition of 1-2-3 compound), then the added chemical step ensures that the constituents will be formed and that other "impurity" phases will not be formed.

Two other known forms of the coprecipitation method have been tried, namely the citrate and oxalate methods. In each case, the nitrates of the constituent powders are first dissolved in solution. Then, in the citrate method, citric acid and ethylene glycol are used to initate the precipitation instead of $Na_2CO_3$ or $K_2CO_3$. In the oxalate method, potassium oxalate is used. These methods must be monitored closely and in the oxylate method the pH must be strictly monitored to avoid formation of double salts.

The product of both the solid-state processes as well as the coprecipitation methods is typically a powder or sintered spongy compact, which is difficult to manufacture into applications such as wires, fibers, films or coatings.

A solution process has been used for fabricating superconducting ceramics. This process comprises the steps of preparing a solution containing organometallic precursor molecules wherein the relative molar ratios of said organometallic precursor molecules are in the appropriate amounts for producing electrically superconducting ceramic material; treating said mixture of organometallic precursor molecules to form a viscous dielectric material; shaping said viscous dielectric material into a particular shape; and heating the shaped viscous material for a sufficient time and at a sufficient temperature to convert said viscous material into an electrically superconducting ceramic article.

This example also discloses the use of a sol-gel process to fabricate $YBa_2Cu_3O_7$-x superconducting fibers. This process involves controlling the hydrolysis and polymerization of metal alkoxides to form primarily chain-like metaloxane polymers which are then shaped into desired fibers and heat treated to form a superconducting material. The fibers produced from this process showed the superconducting transition temperature to be about 90K. This application also discloses the use of 2-ethyl-hexanoic acid (2-EHA) as an organic acid modifier which reduces the hydrolysis and polymerization rates of the metal alkoxides, thus preventing precipitation. Once the yttrium, barium and copper alkoxide solutions were fully reacted, the solvent was removed and the solutions became viscous after a few hours due to the hydrolysis and polymerization of the alkoxides. Up to the present time, however, no method has disclosed the use of a dual solvent system for the preparation of superconducting materials. The advantages of such a system allows for enhanced control over the formation of a viscous pre-ceramic which can be shaped and heat treated to form the superconductive state.

It is an object of this invention to provide an improved method of making a shaped superconducting ceramic article. It is a further object of this invention to provide an improved pre-ceramic resinous material.

According to one aspect of this invention there is provided a method of making a shaped superconducting ceramic article which comprises the steps of:

mixing together respective solutions of a rare earth metal alkoxide, an alkaline earth metal alkoxide and an organic copper salt and refluxing the combined solution obtained therefrom at temperatures of about 40°C to about 82°C for a time sufficient to obtain a maximum amount of precipitate;

hydrolyzing the precipitate in a first solvent system comprising a water/alcohol solution under heat to substantially dissolve the precipitate;

drying the resulting pre-ceramic material;

mixing said pre-ceramic material with a sufficient quantity of a binary mixture of a polar and a non-polar solvent to produce a softened, shapable mass; and

shaping said mass into a desired configuration.

According to another aspect of this invention there is provided a pre-ceramic resinous material mass capable of being shaped and further capable of being converted into an electrically superconducting ceramic material which comprises a pre-ceramic material having substantially stoichiometric amounts of rare earth metal alkoxide, barium alkoxide and organic copper salt required to produce a compound having the formula $ABa_2Cu_3O_7$-x, a polar solvent and a non-polar solvent.

One embodiment of the instant invention concerns a method of making superconducting articles such as fibers, wires, ribbons, films, bulk solids and the like using a precipitate process which employs specific parameters for hydrolysis and a second solvent system to effectuate control of the pre-ceramic viscosity.

More particularly, one embodiment of this invention relates to formation of a pre-ceramic resinous material, also known in the art as a superconductor precursor, which remains in the stable dry state at ambient temperatures, and which can be softened or dissolved in a binary mixture of polar and non-polar solvents to achieve the desired viscosity for processing into shapes.

Additionally, one embodiment of this invention concerns the method of producing the pre-ceramic resinous material. Another embodiment concerns the structure and physical state of the pre-ceramic resinous material. A further embodiment relates to a method of producing flexible and mechanically strong pre-ceramic articles such as thin fibers, wires and the like which are capable of being made superconductive. The superconductive transition temperature $T_c$ of these materials is about 84K-89K with a superconductive onset temperature of about 87K-91K.

More particularly, one embodiment of this invention concerns a method of making a pre-ceramic material capable of being converted into an electrically superconductive ceramic material having perovskite structure comprising the steps of: i) mixing together respective solutions of a rare earth metal alkoxide, an alkaline earth metal alkoxide and an organic copper salt and refluxing the combined solution obtained therefrom at temperatures of about 40°C to about 82°C for a time sufficient to obtain a maximum amount of precipitate; ii) hydrolizing the precipate in a first solvent system comprising a water/alcohol solution under heat to substantially dissolve the precipitate; iii) removing sufficient solvent to obtain the desired state of the thus formed pre-ceramic resin material; iv) mixing the pre-ceramic resin material with a second solvent system comprising a non-polar solvent; and v) removing sufficient solvent to control the resultant flow properties of the pre-ceramic resin material.

Yttrium, barium, and copper are the preferred constituents of the final superconductive material and they may be generally present in stoichiometric amounts in the final composition, although non-stoichiometric amounts are contemplated, e.g., the final composition may have $Y_2BaCuO_5$ present where Y is from 0.005 to 0.40. However, as will be later described, the instant method can be applied using a variety of rare earth metals, as well as partial substitution of other alkaline earth metals for barium.

Thus, the instant invention may also contemplate a method of making a yttrium/barium/cuprate superconducting material having the structure $YBa_2Cu_3O_7$-x.

Reference is now made to the accompanying drawings in which;

Figure 1 is a phase diagram representing the relationship among a mixture of the pre-ceramic resign, benzene and isopropanol;

Figure 2 is a phase diagram representing the relationship among a second mixture of the pre-ceramic resin, tluene and isopropanol;

Figure 3 is a phase diagram representing the relationship among a mixture of pre-ceramic resin, xylene and isopropanol;

Figure 4 is a phase diagram representing the relationship among a mixture of the pre-ceramic resin, hexane and isopropanol;

Figure 5 is a phase diagram representing the relationship among the pre-ceramic resin, cyclohexane and isopropanol; and

Figure 6 is a phase diagram representing the relationship among the pre-ceramic resin, isooctane and isopropanol.

In preparing the superconducting materials of the instant invention, several factors are important to the quality of the final product. Stoichiometry, the preparation of the pre-ceramic, the sintering temperature, the use of oxygen in the process and the rate of cooling are five such factors. These factors will affect the transition temperature, $T_c$, the transition width, the room temperature resistance as well as
the phase purity of the final 1-2-3 orthorhombic crystal structure. A slight change in stoichiometry for example, from $Y_1Ba_2Cu_3O_7$-x to $Y_{1.05}BA_{1.8}Cu_{3.0}O_7$-x has been shown to decrease the zero resistance transition temperature, $T_c$, from 90K to 60K,' and increase the resistive transition width from 1K to 5K. For this reason, solution condensed phase techniques may be favored.

The sintering and/or annealing processes must also be carried out with care. Temperatures may vary according to the particular material, but sintering is carried out at temperatures of from about 800°C to about 1000°C for about eight to twenty-four hours, followed by annealing at about 360°C to about 500°C for about four to about forty-eight hours. This is performed under a dry oxygen atmosphere. The high temperature sintering is generally necessary to ensure that the correct (crystalline) structure is formed.

As previously discussed, the instant process of preparing high $T_c$ perovskite type (1-2-3) superconductors has a distinct advantage over the prior art coprecipitate or solution methods due to the ability to form dry pre-ceramic resin which can be stored until needed, and then softened or dissolved in a mixture of a non-polar solvent and a polar solvent to the desired viscosity. Thus, the products of this invention are stable and do not undergo viscosity changes over time as the current sol-gel or coprecipitate methods. In the sol-gel methods, the time for drawing a fiber from the resin must be chosen within a narrow window of time and must be balanced with the sol to gel transition. Once the gel sets up, it is difficult to form into the desired shape. The instant invention clearly overcomes this problem since the pre-ceramic resin can be stored and redissolved at anytime at will to obtain the desired viscosity.

One embodiment of the inventive process involves the preparation of high $T_c$ 1-2-3 superconductors of the perovskite type, having the general formula $ABa_2Cu_3O_7$-x, where A is a rare earth metal and x is from 0.5 to 0. Thus, a superconductive ceramic having perovskite structure of the above formula can be made by the process comprising: i) refluxing a rare earth metal alkoxide/alkyl ($C_{2-6}$) alcohol (dry) solution with an alkaline earth metal alkoxide/alkyl ($C_{2-6}$) alcohol (dry) solution under inert atmosphere; ii) adding to this solution an acidic organic copper salt/alkyl ($C_{2-6}$) alcohol solution to obtain a precipitate while continuing to reflux; iii) maintaining the precipitate at about 20°C to about 82°C for up to two hours under inert atmosphere; iv) adding a water/alkyl ($C_{2-6}$) alcohol solution in amounts of about two to about ten equivalents of water per mole of rare earth metal alkoxide to obtain a homogeneous dark green solution; v) removing the solvent to obtain a viscous or dry pre-ceramic resinous material; vi) dissolving or softening the pre-ceramic resinous material in a mixture of polar and non-polar solvent to obtain a desired viscosity; vii) forming a desired shape from the viscous pre-ceramic material; viii) slowly heating the shaped pre-ceramic article in a dry oxygen atmosphere up to about 800°C to about 1000°C and sintering for about eight to about twenty-four hours; and ix) annealing the article at about 360°C to about 500°C for about four to about forty-eight hours to form a superconductive article having perovskite structure.

The rare earth metal "A" in the aforementioned structure can be any of the rare earth metals known to be useful in superconducting materials. Non-limiting examples include yttrium, erbium, europium, gadolinium, holmium, lutetium, samarium and dysprosium. Yttrium is preferred.

Although barium is the preferred alkaline earth metal, at least partial substitution with other alkaline earth metals such as strontium, calcium and alkali metals such as potassium are contemplated. Mixtures are also contemplated.

The alkoxides of the rare earth metals and alkaline earth metals may be selected from the group consisting of ethoxides, propoxides, isopropoxides, butoxides, pentoxides, and mixtures thereof. Thus, yttrium ethoxide, yttrium propoxide, yttrium isopropoxide, yttrium butoxide as well as yttrium pentoxide are deemed useful. Yttrium isopropoxide is preferred. Similarly, barium ethoxide, barium propoxide, barium isopropoxide, barium butoxide and barium pentoxide are contemplated. Barium isopropoxide is preferred.

The alkoxides are present in corresponding alkyl ($C_{2-6}$) alcohol solutions. For example, ethanol, propanol, isopropanol, butanol, pentanol and hexanol are examples of useful alcohols. The preferred alcohol is isopropanol. The alcohol should be dry.

The acidic organic copper salt is also present in an alkyl alcohol ($C_{1-6}$) solution prior to its incorporation with the rare earth and alkaline earth metal alkoxide/alcohol solutions. The organic copper salt most preferred is copper ethylhexanoate, although other acidic organic copper salts are useful. In addition to the copper ethylhexanoate, a member selected from the group consisting of copper trifluoroacetate, copper trichloroacetate, copper difluoroacetate, copper dichloroacetate, copper monofluoroacetate, and copper monochloroacetate may be added in sufficient quantities to prevent the formation of undesirable $BaCO_3$, by favoring the formation of $BaX_2$ where "X" is chlorine or fluorine. Copper trifluoroacetate is preferred. However, the copper trifluoroacetate should only be used in amounts necessary to generate $BaF_2$. For example, the copper ethylhexanoate to copper trifluoroacetate ratio can be 2:1, 7:1, 10:1, etc.

The refluxing of step i) is carried out at the boiling point of the solution under nitrogen for about one to two hours. Other inert atmospheres such as helium or argon may be used. At this point, the organic copper salt (copper ethylhexanoate)/alcohol (isopropanol) solution was added and refluxing was continued. A green precipitate was formed and the reaction was maintained at about 20°C to about 82°C for up to two hours under inert (nitrogen) atmosphere.

Step iv) involves the addition of a water/alkyl ($C_{1-6}$) alcohol solution. The preferred alcohol is isopropanol. This solution is added in critical amounts of about two to about ten equivalents of water per mole of rare earth metal alkoxide (e.g., yttrium isopropoxide). The precipitate dissolves, forming a dark green homogeneous solution, which is stirred from one to twenty-four hours at temperatures ranging from 40°C to 80°C. At this point, the solvent is removed by rotary evaporation to obtain a dry pre-ceramic resinous mass. The dry mass was then dissolved in a non-polar solvent/polar solvent solution. The preferred non-polar solvents are pentane, hexane, heptane, octane, decane, docane, dodecane, cyclohexane, methylcyclohexane, 2-methylhexane, 3-methylhexane, 2,3-dimethylpentane, 2,4-dimethylpentane, ethylcyclohexane, 2,2,4-trimethylpentane, naphthalene, p-xylene, m-xylene, o-xylene, cyclohexene, 1-pinene, 1-hexene, 1-heptene, 1-octene, 1-decene, hexafluorobenzene, ethylbenzene, isopropylbenzene, 2-pinene, beta-pinene and mixtures thereof.

The preferred polar solvents, in addition to the alcohols discussed above, include propane-l,3-diol, propane-l,2-diol, 2-ethyl-pentane-2,4-diol, 2,3-dimethylbutane-2,3-diol, hexanone, alpha-terpineol, 4-hydroxy-4-methyl-2-pentanone and mixtures thereof.

For fiber spinning optimum results are obtained where the dry resin powder is mixed with a binary solvent comprising of from about 5 to 70 wt % non-polar solvent and up to about 5 wt % of the polar solvent, based on the total weight of the resin/binary solvent mixture. For film and coating preparation, optimum results are obtained with a binary solvent mixture comprising from about 10 to 90 wt % non-polar solvent, and from about 4 to 80 wt % polar solvent, based on the total weight of the resin/binary solvent mixture.

The ratio of pre-ceramic resin to non-polar/polar solvent solution is about 15:1 to about 1.5:1 by weight.

It has been determined that the non-polar/alcohol solution of pre-ceramic resin comprising one of the following compositions is particularly good for the drawing of fibers:

    A) 0-17% alcohol (isopropanol)

    2-55% benzene

    28-98% pre-ceramic resin material; or

    B) 0-14.9% alcohol (isopropanol)

    2-65% toluene

    20-98% pre-ceramic resin material; or

    C) 0-18% alcohol (isopropanol)

    7-60% xylene

    16-93% pre-ceramic resin material.

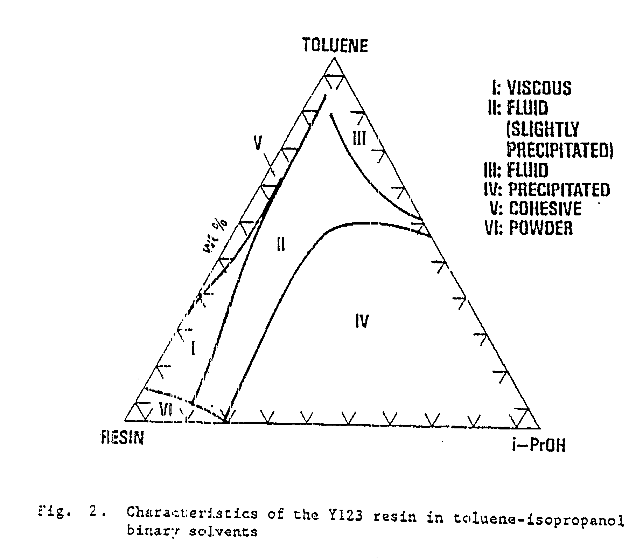

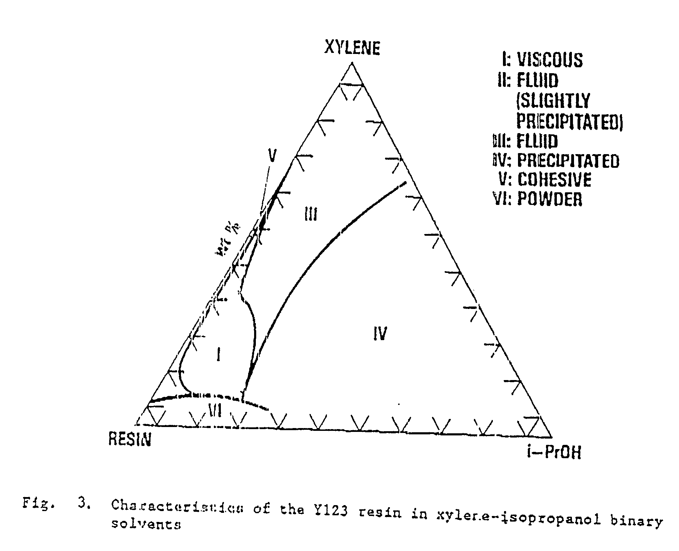

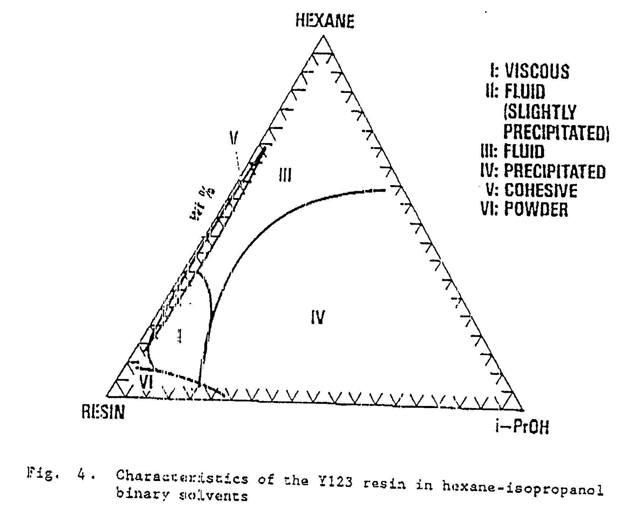

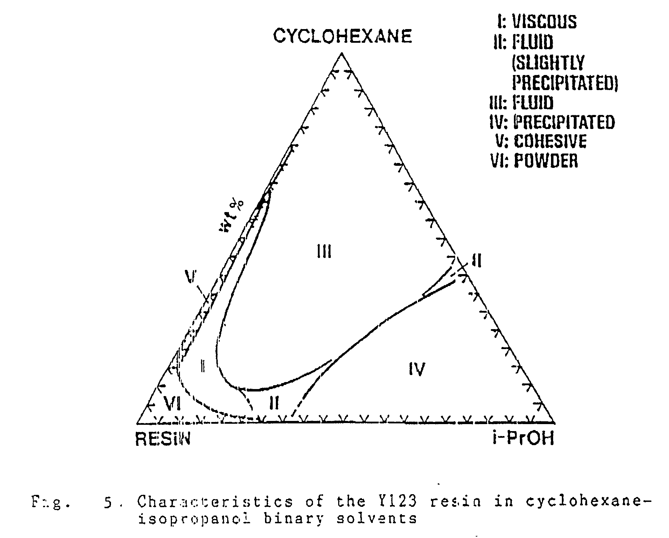

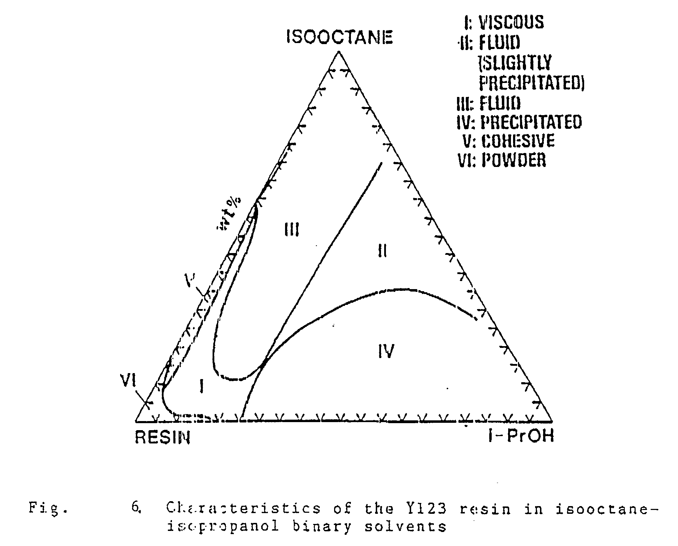

These are among numerous possible combinations which may be used. Suitable viscosities can be easily adjusted by using different solvent combinations and different ratios. There are special cases where the fiber drawing range can be extended to 75% weight of either benzene, toluene or xylene. This can be seen in the tie-lines between benzene-resin, toluene-resin and xylene-resin as evidenced in Figures 1, 2 and 3 respectively. Superior results are obtained with solvent mixtures of hexane and isopropanol as shown in Figure 4, cyclohexane and isopropanol as shown in Figure 5 and isooctane and isopropanol as shown in Figure 6. These figures are phase graphs of the drawing solutions indicating the various phases, e.g., fluid colloidal, viscous, cohesive, etc. as a function of non-polar solvent type and weight percent of the pre-ceramic non-polar solvent and isopropanol components.

Another aspect of the invention concerns a pre-ceramic resinous material capable of being converted into an electrically superconductive ceramic material having perovskite structure and conforming to the formula $ABa_2Cu_3O_{7-x}$ where A is a rare earth metal and x is from 0.5 to 0, said pre-ceramic resinous material having approximate stoichiometric amounts of rare earth metal alkoxide, barium alkoxide, and organic copper salt present and being soluble in both water/alcohol solution and non-polar solvent/alcohol solutions.

## EXAMPLE I
### Preparation of Starting Materials

A yttrium isopropoxide/isopropanol 0.01M - 0.3M solution was prepared by reacting a yttrium metal chip in dry isopropanol and a small amount of $HgCl_2$ as a catalyst and refluxing at about 82° C until completion of the reaction (about three days). The mixture was filtered to obtain a clear solution.

A barium isopropoxide/isopropanol 0.01M - 0.3M solution was prepared by placing barium metal in dry isopropanol, then filtered and stored in a nitrogen dry box.

A copper ethylhexanoate/isopropanol 0.01M - 0.3M solution can be prepared by mixing copper ethylhexanoate in dry isopropanol. The copper ethylhexanoate was commercially purchased, however.

A copper trifluoroacetate can be prepared by reacting copper methoxide or copper ethoxide with trifluoroacetic acid.

### Preparation of Pre-Ceramic Resin

A precalculated volume of barium isopropoxide/isopropanol solution was pipetted into a round bottom flask and the appropriate volume of yttrium isopropoxide/isopropanol was added. Stoichiometric amounts were used (to give the final ceramic composition $YBa_CCu_3O_{7-x}$). The solution was refluxed at its boiling point under nitrogen for about two hours. The required amount of copper ethylhexanoate $(Cu(EH)_2)$ was added. A green precipitate formed and was kept at 20° C to 80° C for two hours under dry nitrogen. A water/isopropanol solution using ten equivalents of water per mole of yttrium isopropoxide was added and the green precipitate gradually dissolved forming a dark green homogeneous solution. The solution was stirred for about four hours at a temperature of about 60° C. This solution was concentrated on a rotary evaporator to obtain a dry mass. This mass was dissolved in a benzene/isopropanol solution in a ratio of 10:1 by weight and concentrated by removing the solvent on a rotary evaporator. A dry resin-like mass was obtained. The dry pre-ceramic mass was redissolved in a benzene/isopropanol solution having 3% isopropanol, 20% benzene and 77% resin. Fibers were drawn by hand by dipping in a glass rod and drawing the viscous solution. The fibers solidified to a mechanically strong structure and did not easily break on handling yet they had excellent flexibility. No brittleness was present.

The fibers were converted to yttrium barium cuprate superconducting fibers by heat treating in dry oxygen slowly from 800° C to 1000° C, sintered for twenty-four hours and annealed at 360° C to 500° C for forty-eight hours.

Additional fibers made using a mixture of copper ethylhexanoate and copper trifluoroacetate (2:1) required heat treatment in a water-containing atmosphere from 500° C to 900° C for six to twenty-four hours prior to switching to a dry oxygen atmosphere at 900° C to 1000° C for four to twenty-four hours.

The $T_c$ of the fibers were tested using the standard four-probe technique. Silver epoxy (paste) was used for electrical contacts. A small ac current (0.1 mA) was supplied by an ac power supply. The $T_c$ R = 0 was found to be 84K - 87K with an onset of 87K - 91K.

## EXAMPLE II

A dry, resin-like pre-ceramic mass was prepared as described in Example I. Quantities of isopropanol and cyclohexane are mixed with a portion of the dry resin so as to produce a mixture having about 50 wt % cyclohexane and about 2 wt % isopropanol. The mixture is found to be particularly suitable for hand drawing and mechanical spinning. The remaining dry resin is mixed with isopropanol and isooctane to produce a mixture having about 30 wt % isooctane and about 5 wt % isopropanol. The resulting mixture is found to be particularly suitable for use in film forming and as a coating.

While the particular method for preparing pre-ceramic resins as herein shown and disclosed in detail is fully capable of obtaining the objects and providing the advantages herein before stated, it is to be understood that it is merely illustrative of the presently preferred embodiments of the invention and that no limitations are intended to the details of construction or design herein shown other than as defined in the appended claims.

## Claims

1. A method of making a shaped superconducting ceramic article which comprises the steps of:

mixing together respective solutions of a rare earth metal alkoxide, an alkaline earth metal alkoxide and an organic copper salt and refluxing the combined solution obtained therefrom at temperatures of about $40\,^\circ$C to about $82\,^\circ$C for a time sufficient to obtain a maximum amount of precipitate;

hydrolyzing the precipitate in a first solvent system comprising a water/alcohol solution under heat to substantially dissolve the precipitate;

drying the resulting pre-ceramic material;

mixing said pre-ceramic material with a sufficient quantity of a binary mixture of a polar and a non-polar solvent to produce a softened, shapable mass; and shaping said mass into a desired configuration.

2. A method according to Claim 1, further comprising the steps of:

heating the shaped mass in a dry oxygen atmosphere slowly up to about $800\,^\circ$C to about $1000\,^\circ$C and sintering for about 8 to 24 hours; and

annealing the resulting article at about $360\,^\circ$C to about $500\,^\circ$C in an oxygen atmosphere for about 4 to 48 hours to form a final superconductive article.

3. A method according to Claim 1 or 2 wherein said polar solvent is selected from the group consisting of alkyl ($C_{1-6}$) alcohols, propane-1,3-diol, propane-1,2-diol, 2-ethyl-pentane-2,4-diol, 2,3-dimethylbutane-2,3-diol, haxanone, alpha-terpineol, 4-hydroxy-4-methyl-2-pentanone and mixtures thereof.

4. A method according to Claim 1 or 2, wherein said non-polar solvent is selected from the group consisting of pentane, hexane, heptane, octane, decane, docane, dodecane, cyclohexane, methycyclohexane, 2-methylhexane, 3-methylhexane, 2,3-dimethylpentane, 2,4-dimethylpentane, ethylcyclohexane, 2,2,4-trimethylpentane, naphthalene, p-xylene, m-xylene, o-xylene, cyclohexene, 1-pinene, 1-hexene, 1-heptene, 1-octene, 1-decene, hexafluorobenzene, ethylbenzene, isopropylbenzene, 2-pinene, beta-pinene and mixtures thereof.

5. A method according to any preceding Claim, wherein said mass is shaped into fibers by hand drawing or mechanical spinning and said binary solvent mixture comprises from about 5 to 70 wt% non-polar solvent and up to about 5 wt% polar solvent based on the total weight of the resin-binary solvent mixture.

6. A method according to any preceding claim, wherein said mass is shaped into a film or coating and said binary solvent mixture comprises from about 10 to 90 wt% non-polar solvent and from about 4 to 89 wt% polar solvent, based on the total weight of the resin-binary solvent mixture.

7. A method according to any preceding claim, wherein said rare earth metal is yttrium.

8. A method according to any preceding claim, wherein said alkaline earth metal is barium.

9. A method according to any preceding claim, wherein rare earth metal molecules, alkaline earth metal molecules and copper molecules are present in said mass in amounts which will produce a superconductive material having the structure $ABa_2Cu_3O_{7-x}$, where A is a rare earth metal and x is from 0.5 to 0.

10. A pre-ceramic resinous material mass capable of being shaped and further capable of being converted into an electrically superconducting ceramic material which comprises a pre-ceramic material having substantially stoichiometric amounts of rare earth metal alkoxide, barium alkoxide and organic copper salt required to produce a compound having the formula $ABa_2Cu_3O_{7-x}$, a polar solvent and non-polar solvent.

11. A pre-ceramic resinous material mass according to Claim 10, wherein said polar solvent is selected from the group consisting of alkyl ($C_{1-6}$) alcohols, propane-1,3-diol, propane-1,2-diol, 2-ethyl-pentane-2,4-diol, 2,3-dimethylbutane-2,3-diol, hexanone, alpha-terpineol, 4-hydroxy-4-methyl-2-pentanone and mixtures thereof.

12. A pre-ceramic resinous material mass according to Claim 10, wherein said non-polar solvent is selected from the group consisting of pentane, hexane, heptane, octane, decane, docane, dodecane, cyclohexane, methylcyclohexane, 2-methylhexane, 3-methylhexane, 2,3-dimethylpentane, 2,4-dimethylpentane, ethylcyclohexane, 2,2,4-trimethylpentane, naphthalene, p-xylene, m-xylene, o-xylene, cyclohexene, 1-pinene, 1-hexene, 1-heptene, 1-octene, 1-decene, hexafluorobenzene, ethylbenzene, isopropylbenzene, 2-pinene, beta-pinene and mixtures thereof.

13. A pre-ceramic resinous material mass according to any of Claims 10 to 12, wherein said mass in the form of fibers and said binary solvent mixture comprises from about 5 to 70 wt% non-polar solvent and up to about 5 wt% polar solvent based on the total weight of the resin-binary solvent mixture.

14. A pre-ceramic resinous material mass according to any of Claims 10 to 13, wherein said mass is in the form of a film or coating and said binary solvent mixture comprises from about 10 to 90 wt% non-polar solvent and from about 4 to 89 wt% polar solvent, based on the total weight of the resin-binary solvent mixture.

Fig. 1. Characteristics of the Y123 resin in benzene-isopropanol binary solvents

Fig. 2. Characteristics of the Y123 resin in toluene-isopropanol binary solvents

XYLENE

I: VISCOUS
II: FLUID
(SLIGHTLY
PRECIPITATED)
III: FLUID
IV: PRECIPITATED
V: COHESIVE
VI: POWDER

RESIN

i—PrOH

Fig. 3. Characteristics of the Y123 resin in xylene-isopropanol binary solvents

Fig. 4. Characteristics of the Y123 resin in hexane-isopropanol binary solvents

Fig. 5. Characteristics of the Y123 resin in cyclohexane-isopropanol binary solvents

Fig. 6. Characteristics of the Y123 resin in isooctane-isopropanol binary solvents

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 301 591   (MITSUBISHI K.K.K.)<br>* Examples *<br>— — — | 1-2,6-9 | C 04 B<br>35/00<br>C 01 G 3/00 |
| X | EP-A-0 280 292   (SUMITOMO ELECTRIC INDUSTRIES LTD)<br>* Examples; claims *<br>— — — | 10,12-14 | |
| A | | 1-14 | |
| A | EP-A-0 237 081   (MATSUSHITA ELECTRIC INDUSTRIAL)<br>* Whole document *<br>— — — | 1-14 | |
| A,P | JP-A-1 294 536   (MITSUBISHI METAL CORP.)<br>* Abstract *<br>— — — — — | | |

TECHNICAL FIELDS
SEARCHED (Int. Cl.5)

C 04 B
C 01 G

The present search report has been drawn up for all claims

| Place of search | Date of completion of search | Examiner |
|---|---|---|
| The Hague | 05 March 91 | HARBRON J.L. |